(19) Europäisches Patentamt / European Patent Office / Office européen des brevets

(11) **EP 2 398 080 B1**

(12) **EUROPÄISCHE PATENTSCHRIFT**

(45) Veröffentlichungstag und Bekanntmachung des Hinweises auf die Patenterteilung:
**14.08.2019   Patentblatt 2019/33**

(51) Int Cl.:
***H01L 33/48*** *(2010.01)*

(21) Anmeldenummer: **11181590.8**

(22) Anmeldetag: **09.06.2004**

(54) **Leuchtdioden-Lichtquelle**

Light emitting diode based light source

Source lumineuse à diode électroluminescente

(84) Benannte Vertragsstaaten:
**AT BE BG CH CY CZ DE DK EE ES FI FR GB GR HU IE IT LI LU MC NL PL PT RO SE SI SK TR**

(30) Priorität: **11.07.2003   AT 10722003**

(43) Veröffentlichungstag der Anmeldung:
**21.12.2011   Patentblatt 2011/51**

(62) Dokumentnummer(n) der früheren Anmeldung(en) nach Art. 76 EPÜ:
**04741760.5 / 1 839 344**

(73) Patentinhaber: **Tridonic Jennersdorf GmbH**
**8380 Jennersdorf (AT)**

(72) Erfinder: **Leising, Günther**
**8042 Graz (AT)**

(74) Vertreter: **Rupp, Christian**
**Mitscherlich PartmbB**
**Patent- und Rechtsanwälte**
**Sonnenstraße 33**
**80331 München (DE)**

(56) Entgegenhaltungen:
WO-A2-2004/088760    DE-A1- 19 963 264
JP-A- H0 637 359     JP-A- S6 072 281
JP-A- H08 264 841    JP-A- H11 168 235
JP-A- 2003 017 754   JP-A- 2003 115 204
US-A1- 2002 001 192  US-B1- 6 531 328

EP 2 398 080 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

**Technisches Umfeld**

Die vorliegende Erfindung betrifft eine LED-Lichtquelle mit einer oder mehreren auf einer Platine angeordneten LEDs, wobei die Platine Kontaktflächen aufweist, mit denen die LEDs kontaktiert sind.

LED-Lichtquellen haben normalerweise folgenden Aufbau:

Der LED-Die ist mittels eines Die-Attachs auf eine Kontaktfläche (z.B. Leiterbahn) eines LED-PCBs aufgebracht. (PCB = printed circuit board; der Begriff Die-Attach umfasst sowohl einen Die-Kleber als auch eine Löt-Verbindung.) Zusammen mit den Rückseitenkontakten des LED-PCB stellt diese Anordnung eine eigene LED-Lampe dar. Diese LED-Lampe wird mittels einer Bestückungstechnik (z.B. SMT) auf eine Platine assembliert, die dann optional mit einem Kühlkörper verbunden wird. Optional kann die Lampe in einem Lampensockel befestigt und kontaktiert werden. Statt auf einer Platine kann die LED auch auf einem Stecker assembliert werden.

Um LED-Anwendungen mit hoher Helligkeit zu realisieren, werden immer stärkere Hochleistungs-LEDs eingesetzt, auch schon mit einer Betriebsleistung von mehr als 1 $W_{e1}$. Die Chipfläche dieser LEDs liegt derzeit im Bereich von 1 mm$^2$. Es zeichnet sich der Trend ab, dass in Zukunft die Betriebsleistung pro LED weiter erhöht wird, was einerseits durch größere Halbleiter und andererseits durch höhere Stromdichten erreicht wird. Speziell letzterer Parameter bewirkt, dass die Leistungsdichten von LEDs von derzeit maximal 1-2 $W_{e1}$/mm$^2$ in Zukunft auf über 4 $W_{e1}$/mm$^2$ ansteigen werden.

Allerdings sind für das Abführen der Verlustwärme hierzu entsprechende Anordnungen zu realisieren, die es gestatten, die Wärme ausreichend vom Halbleiter abzuführen.

Eine zu hohe Erwärmung während des Betriebes der LEDs führt zu einer Bauteilzerstörung. Aus diesem Grund muss während des Betriebes der LED gewährleistet werden, dass die Temperatur an der Sperrschicht des p-n-Übergangs in der LED nicht über typischerweise 130°C steigt. Dies kann insofern während des Betriebes der LEDs eintreten, da nur ein Teil der vom Bauelement aufgenommenen elektrischen Leistung in Licht umgesetzt wird, während der andere Teil in Wärme umgewandelt wird. (Derzeit ist die Leistungseffizienz von LEDs kleiner als 10%.) Die Betriebsparameter von LEDs sind daher in Abhängigkeit von der Art der Assemblierung, der Einbau- und Umgebungsbedingungen derart zu wählen, dass die Sperrschichttemperatur immer unter 130°C bleibt

In gegenständlicher Erfindung werden Anordnungen vorgestellt, welche die Verlustwärme von LEDs derart effizient abführen können, dass Leistungsdichten von über 2 $W_{e1}$/mm$^2$ abgeführt werden können.

Um die Verlustwärme effizient abzuführen, muss der thermische Widerstand der Anordnung optimiert werden. Wenn die Wärme ohne hohe Temperaturabfälle auf den LED-Träger übertragen werden kann, bleibt die Sperrschicht unter der maximal zulässigen Temperatur. Der wesentliche physikalische Parameter ist also der thermische Widerstand, gemessen in K/W.

Anordnungen und Aufbauten, wie diese derzeit für High-Power-LEDs Stand der Technik sind, weisen in optimierten Anordnungen typisch einen thermischen Widerstand von mehr als 20K/W (Übergang Junction zu LED Tragermaterial) auf. Dies bedeutet, dass der Temperaturunterschied zwischen dem LED-Träger und der aktiven Zone der LED - bei Betrieb mit 5 $W_{e1}$ - mehr als 100K beträgt. Ausgehend von einer maximal zulässigen Sperrschichttemperatur für Langzeitanwendungen von 130°C bedeutet dies, dass bei Temperaturen über 30°C ein Einsatz unmöglich ist, und daher ist diese LED für viele technische Anwendungen (Automobil, Verkehr) ungeeignet.

US 2002/0001192 A1, JP 06-037359 A, JP 08-264841 A, US 6531328 B1 und DE 19963264 A1 offenbaren LED-Lichtquellen.

**Offenbarung der Erfindung**

**Technisches Problem**

Es ist Aufgabe der vorliegenden Erfindung, eine LED-Lichtquelle der eingangs genannten Art zu schaffen, bei der der thermische Widerstand geringer ist als gemäß dem Stand der Technik.

**Technische Lösung**

Diese Aufgabe wird durch eine LED-Lichtquelle gemäß Anspruch 1 gelöst, wobei die Rückseitenkontakte mindestens die halbe Fläche, vorzugsweise bis auf notwendige Ausnahmen die gesamte Fläche des LED-PCB abdecken. Die notwendigen Ausnahmen sind z.B. die zur elektrischen Isolation notwendigen Beabstandungen von Leiterbahnen auf unterschiedlichem elektrischen Potential.

Bisher wurden die Kontaktflächen immer nur im Hinblick auf den elektrischen Widerstand dimensioniert und daher mit im Verhältnis zur Erfindung geringerer Querschnittsfläche ausgeführt. Erfindungsgemäß sollen diese Kontaktflächen aber möglichst groß sein, wodurch der thermische Widerstand entsprechend herabgesetzt wird. Dabei ist es günstig, dass die thermische und elektrische Leitung senkrecht durch das Trägermaterial durchgeführt wird. Derart kann ein möglichst kompakter Aufbau (ohne räumlich ausgedehnte seitliche Kontakte) realisiert werden.

Es ist günstig, wenn die Rückseitenkontakte mit den Kontaktflächen auf der dem LED-Die zugewandten Seite seitlich des LED-PCB thermisch und gegebenenfalls elektrisch verbunden sind. Dies verbessert nicht nur den thermischen Widerstand, sondern auch die Löt- und Kontaktiereigenschaften.

Bei isolierenden Platinen (z.B. bei organischen LED-PCBs) bringt man den LED-Die normalerweise auf einer Leiterbahn an. Bei Metallkemplatinen müssen die Leiterbahnen allerdings gegenüber dem Metallkern isoliert sein. Diese Isolierschicht erhöht natürlich den thermischen Widerstand. Aus diesem Grunde ist es zweckmäßig, dass der LED-Die direkt auf dem Metallkern angebracht ist.

Bei einer Metallkernplatine kann man zwischen den Leiterbahnen und dem Metallkern ein elektrisch nichtlineares Isolatormaterial anordnen. Da LEDs mit relativ geringer Spannung betrieben werden, kann man das Isolatormaterial prinzipiell sehr dünn ausführen, ohne dass im Betrieb ein Durchschlag zu befürchten ist. Allerdings kann beim Hantieren z.B. durch statische Aufladung eine höhere Spannung entstehen, die bei dünnem Isolatormaterial zu einem Durchschlag führen und damit die LED unbrauchbar machen könnte. Dies wird mit einem elektrisch nichtlinearen Isolatormaterial verhindert, weil dieses ab einer bestimmten Spannung leitend wird. Dadurch wird statische Elektrizität abgeleitet, ohne dass ein Schaden entsteht. Mit einem elektrisch nichtlinearen Isolatormaterial kann man also mit einer geringeren Dicke auskommen, was den thermischen Widerstand entsprechend reduziert.

Wenn der LED face-down auf dem LED-Die montiert ist, ist die Lichtausbeute höher, weil dann kein Licht von den sonst notwendigen Bond-Drähten abgeschattet wird.

Bei einer LED-Lichtquelle der eingangs genannten Art wird die oben genannte Aufgabe erfindungsgemäß durch eine LED-Lichtquelle gemäß Anspruch 1 gelöst, wobei die Rückseitenkontakte der LEDs auf mindestens der halben Fläche des LED-PCB, vorzugsweise bis auf die notwendigen Ausnahmen vollflächig mit den Kontaktflächen bzw. den Kontakten verlötet sind.

Es ist günstig, wenn auf der Rückseite der Platine ein Kühlkörper angeordnet ist. Dadurch wird die Wärme von der Platine abgeführt, ohne dass dazu Platz auf der Vorderseite der Platine notwendig ist. Der Kühlkörper kann jeglicher metallische Funktionskörper (z.B. ein Gehäuse) und mit beliebiger Verbindungstechnik thermisch mit der Platine verbunden sein.

In diesem Fall ist es weiters günstig, wenn die Platine und/oder das LED-PCB Durchkontaktierungen zur Erhöhung der Wärmeleitfähigkeit aufweist, wobei vorzugsweise die Durchkontaktierungen einen Durchmesser von weniger als 100 $\mu$m aufweisen. Dies gilt insbesondere für Platinen aus organischem Material, deren thermische Leitfähigkeit an sich schlecht ist.

## Kurze Beschreibung von Zeichnungen

Anhand der beiliegenden Zeichnungen wird die Erfindung näher erläutert. Es zeigt:

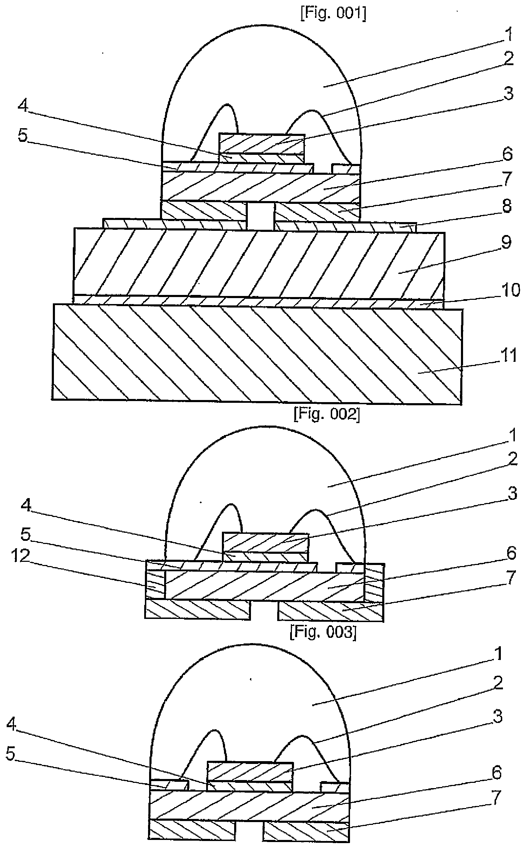

Fig. 1 eine erste Ausführungsform einer nicht erfindungsgemäßen LED-Lichtquelle; Fig. 2 eine Abänderung der in Fig. 1 dargestellten LED; und Fig. 3 eine erfindungsgemäße Abänderung der in Fig. 1 dargestellten LED.

Gemäß Fig. 1 ist ein LED-Die 3 ($R_{th,LED-Die}$) mittels eines Die-Klebers 4 ($R_{th,Die-Kleber}$) auf eine Kontaktfläche (z.B. Leiterbahn 5) eines LED-PCB 6 ($R_{th,LED-PCB}$) aufgebracht. Der LED-Die 3 in Fig. 1 ist face-up montiert und über Bond-Drähte 2 mit den Kontaktflächen (Leiterbahn 5) verbunden. Alternativ hierzu kann dieser auch in einer Face Down Montage direkt auf dem LED-PCB 6 angeordnet sein bzw. dieser auf einem Die-Träger Face Down befestigt sein, und letzterer dann auf der LED PCB angeordnet sein. Zusammen mit den Rückseitenkontakten 7 ($R_{th,Lötpads}$) des LED-PCB 6 stellt diese Anordnung eine eigene LED-Lampe dar. Zur weiteren Verarbeitung kann diese LED-Lampe mittels einer Bestückungstechnik (z.B. SMT) auf eine Platine 9 ($R_{th,Platine}$) as-sembliert werden, die dann optional mit einem Kühlkörper 11 verbunden wird, z.B. über eine Lötfläche 10 ($R_{th,Lötfläche}$).

Der LED-Die 3 ist in einem Material 1 mit entsprechenden optischen Eigenschaften eingegossen. Der LED-Die ist in einen Reflektor eingesetzt. Selbstverständlich können auch mehrere LED-Dies zusammen eingegossen oder in einen Reflektor eingesetzt werden.

Der typische thermische Widerstand der Gesamtanordnung gemäß Fig. 1 setzt sich wie folgt zusammen:

$$R_{th} = R_{th,LED-Die} (4\text{ K/W}) + R_{th,Die-Kleber} (2\text{ K/W}) + R_{th,LED-PCB} (5\text{ K/W}) + R_{th,Lötpads} (3\text{ K/W}) + R_{th,Platine} (2\text{ K/W}) + R_{th,Lötfläche} (2\text{ K/W}) = 18\text{ K/W}$$

Um die Verlötungseigenschaften und die Wärmeabfuhr über die Rückseite zu verbessern, ist es (speziell bei Keramikplatinen und organischen PCBs) zweckmäßig, seitliche Kontaktschichten 12 (siehe Fig. 2) auszuführen, die die Oberseite des PCB mit der Unterseite des PCB thermisch und gegebenenfalls elektrisch verbinden. Hierdurch können die Löteigenschaften der LED-Anordnung sowohl bei manuellem Löten als auch in einer automatischen Anlage (SMT Wellen- oder Reflowlöten) durch besseren Lotangriff sowie bessere thermische Verteilung verbessert werden. Weiters ist die Lötstelle besser von außen zu beurteilen.

Gemäß Fig. 3 ist der LED-Die 3 nicht auf eine Leiterbahn 5 aufgesetzt, sondern direkt auf den Kern des LED-PCB 6. Dies ist bei Metallkernplatinen sinnvoll, weil hier zwischen den Leiterbahnen 5 und dem Metallkern eine dünne Isolationsschicht notwendig ist, um die Leiterbahnen 5 elektrisch zu isolieren. Diese Isolationsschicht erhöht auch den thermischen Widerstand, sodass die direkte Anordnung des LED-Dies 3 auf dem Metallkern des LED-PCB 6 einen kleineren thermischen Widerstand aufweist.

In den Ausführungsbeispielen ist immer von Die-Kleber die Rede, die Dies können aber alternativ dazu auch angelötet sein.

Um den thermischen Widerstand für Hochleistungsanwendungen zu optimieren, sind die thermischen Widerstände der Einzelkomponenten möglichst gering zu halten.

Hierbei ist zu berücksichtigen, dass durch eine Vergrößerung der Fläche der Komponenten nach dem Übergang zum LED-Träger zwar der thermische Widerstand linear abnimmt, anderseits im Hinblick auf eine hohe Integrationsdichte eine Vergrößerung dieser Fläche für viele Anwendungen unerwünscht ist.

Es ist daher günstiger, die materialspezifische thermische Leitfähigkeit der einzelnen Materialien zu optimieren bzw. darüber hinaus die Schichtdicke der Komponenten möglichst dünn zu wählen.

Folgende Möglichkeiten bieten sich an:

I Einsatz von Leitkleber d < 10 $\mu$m mit Leitfähigkeit über 2 W/mK
II Einsatz von Lötkontaktschichten mit thermischer Leitfähigkeit über 20 W/mK und einer Schichtdicke unter 30 $\mu$m
III Kontaktfläche/Trägermaterial

Grundsätzlich können hierzu folgende verschiedene Materialien eingesetzt werden:

III.1 Keramiken (nicht erfindungsgemäß)

Die Keramik weist ein Keramiksubstrat mit Dünnschicht- oder Dickschichtmetallisierung auf. Um die hohen Leistungsdichten abzuführen, werden bevorzugt AlN oder BN eingesetzt, bzw. man verwendet AlO in sehr dünnen Schichten.

III.2 Metallkernplatinen (erfindungsgemäß)

Metallkernplatinen bestehen z.B. aus Cu oder A1. Diese werden mit nichtleitenden Schichten versehen, und darauf sind dann Leiterbahnen angeordnet (entweder galvanisch oder durch Beschichten mittels einer Klebe-/Schweißmethode).

Die Isolationsschicht kann entweder aus organischen Materialien oder dünnen Keramiken bestehen (letztere ist z.B. auf den Metallträger aufgeschlemmt bzw. mit eingebrannten Keramiktapes beschichtet).

Um den thermischen Widerstand der Anordnung weiter zu optimieren, sind bevorzugt möglichst dünne nichtleitende Schichten einzusetzen (dünner als 50 $\mu$m). Dies ist bei LED-Anwendungen grundsätzlich möglich, da LEDs typischer Weise mit einer Gleichspannung von wenigen Volt betrieben werden, sodass keine hohen Durchschlagsfeldstärken auftreten. Allerdings kann es beim Hantieren mit der Leiterplatte zu elektrischen Entladungen kommen. Um diese elektrischen Entladungen abzuführen, werden in einer bevorzugten Variante der Erfindung die Isolatorschichten der Metallkernplatine elektrisch nichtlinear in einer Art ausgeführt, dass diese bei geringen Spannungen (z.B. unter 100 V) elektrisch isolieren, während diese bei hohen Spannungen (z.B. über 100 V) elektrisch leitend werden. Derartige elektrisch nichtlineare Materialien sind im Stand der Technik bekannt. Erfindungsgemäß ist der LED-Die direkt auf den Metallkern aufgesetzt (Fig. 3). Hierbei werden die geringsten thermischen Widerstände erzielt, und man kann ohne Probleme die Isolatorschichten dick ausführen.

Der Nachteil dieser Anordnung ist, dass für den Aufbau gemäß Fig. 1 gesonderte Aufwendungen notwendig sind, um die elektrische Kontaktierung über die Rückseite vorzunehmen.

Dies kann z.B. durch Anordnen von nach außen isolierenden Metallzylindern, die von oben und unten kontaktiert werden können, erfolgen.

III.3 Organische PCBs (nicht erfindungsgemäß)

Im Gegensatz zu den oben dargestellten Varianten ist die thermische Leitfähigkeit des Trägermaterials eines organischen PCB sehr schlecht (nur 0,1-0,2 W/mK). Um mit diesen Materialien dennoch eine ausreichende thermische Leitfähigkeit zu realisieren, kann man in der unmittelbaren Nähe des Die Durchkontaktierungen vorsehen, die zumindest teilweise mit Cu gefüllt sind. Je höher die Anzahl der Durchkontaktierungen, umso geringer wird der thermische Widerstand. Um die Wärme hierzu ausreichend zu spreizen, sind Metallisierungsschichtdicken von über 100 $\mu$m, bevorzugt über 200 $\mu$m notwendig. Typischerweise weisen diese Kanäle einen Durchmesser von einigen Zehntel mm auf. In einer optimierten Variante beträgt der Durchmesser der Kanäle nur wenige Mikro- oder Nanometer. Derart wird ein Substrat mit sehr hoher anisotroper elektrischer und thermischer Leitfähigkeit realisiert.

## Patentansprüche

1. LED-Lichtquelle mit einer oder mehreren auf einer Platine (9) angeordneten LED(s),
   wobei jede der LED(s) mindestens ein LED-Die (3) aufweist der, mittels eines Die-Attachs (4), auf einem LED-PCB (6) angeordnet ist und das LED-PCB (6) an der dem LED-Die (3) gegenüberliegenden Seite elektrische Rückseitenkontakte (7) aufweist,
   wobei die Rückseitenkontakte (7) mindestens die halbe Fläche, vorzugsweise bis auf notwendige Ausnahmen die gesamte Fläche, des LED-PCB (6) abdecken,
   wobei der LED-Die (3) in einem Material (1) eingegossen ist und der LED-Die (3) in einen Reflektor eingesetzt ist,
   wobei das LED-PCB (6) eine Metallkernplatine ist und der LED-Die (3) direkt auf dem Metallkern angebracht ist,
   wobei die Platine (9) Kontaktflächen (8) aufweist, mit denen die eine oder mehrere LED(s) kontaktiert sind, und
   wobei die Rückseitenkontakte (7) der einen oder mehreren LED(s) jeweils auf mindestens der halben Fläche des LED-PCB (6) mit den Kontaktflächen (8) verlötet sind.

2. LED-Lichtquelle nach Anspruch 1, **dadurch gekennzeichnet, daß** mehrere LED-Dies (3) zusammen in dem Material (1) eingegossen sind.

3. LED-Lichtquelle nach Anspruch 1 oder 2, **dadurch gekennzeichnet, daß** mehrere LED-Dies (3) zusammen in einen Reflektor eingesetzt sind.

4. LED-Lichtquelle nach einem der Ansprüche 1-3, **dadurch gekennzeichnet, dass** zwischen Leiterbahnen (5) der Metallkernplatine und dem Metallkern der Metallkernplatine ein elektrisch nichtlineares Isolatormaterial angeordnet ist.

5. LED-Lichtquelle nach einem der Ansprüche 1-4, **dadurch gekennzeichnet, dass** der LED-Die (3) face-down oder face-up auf dem LED-PCB (6) montiert ist.

6. LED-Lichtquelle nach einem der Ansprüche 1-5, **dadurch gekennzeichnet, dass**
   die Rückseitenkontakte (7) der einen oder mehreren LED(s) jeweils bis auf die notwendigen Ausnahmen vollflächig mit den Kontaktflächen (8) verlötet sind.

7. LED-Lichtquelle nach Anspruch 6, **dadurch gekennzeichnet, dass** auf der Rückseite der Platine (9) ein Kühlkörper (11) angeordnet ist.

8. LED-Lichtquelle nach einem der vorhergehenden Ansprüche, **dadurch gekennzeichnet, dass** die Platine (9) und/oder das LED-PCB (6) Durchkontaktierungen zur Erhöhung der Wärmeleitfähigkeit aufweist, wobei vorzugsweise die Durchkontaktierungen einen Durchmesser von weniger als 100 $\mu$m aufweisen.

9. LED-Lichtquelle nach einem der vorhergehenden Ansprüche, bei der der Die-Attach (4) ein Die-Kleber oder eine Anlötung ist.

## Claims

1. LED light source having one or more LEDs disposed on a printed circuit board (9),
   wherein each of the LEDs comprises at least one LED die (3) disposed on an LED PCB (6) by means of a die attach (4), and the LED PCB (6) comprises electrical rear side contacts (7) on the side opposite the LED die (3), wherein the rear side contacts (7) cover at least half the surface, preferably, aside from necessary exceptions, the entire surface of the LED PCB (6),

wherein the LED die (3) is cast in a material (1) and the LED die (3) is inserted into a reflector, wherein the LED PCB (6) is a metal core printed circuit board and the LED die (3) is mounted directly on the metal core,

wherein the printed circuit board (9) comprises contact surfaces (8) with which the one or more LEDs (s) are in contact, and

wherein the rear side contacts (7) of the one or more LEDs are respectively soldered to the contact surfaces (8) on at least half the surface of the LED PCB (6).

2. LED light source according to Claim 1, **characterized in that** a plurality of LED dies (3) are cast in the material (1) together.

3. LED light source according to Claim 1 or 2, **characterized in that** a plurality of LED dies (3) are jointly inserted into a reflector.

4. LED light source according to any one of Claims 1-3, **characterized in that** an electrically non-linear insulator material is arranged between conductor paths (5) of the metal core printed circuit board and the metal core of the metal core printed circuit board.

5. LED light source according to any one of Claims 1-4, **characterized in that** the LED die (3) is mounted face down or face up on the LED PCB (6).

6. LED light source according to any one of Claims 1-5, **characterized in that**, aside from the necessary exceptions, the rear side contacts (7) of the one or more LEDs are respectively soldered to the contact surfaces (8) over the whole surface.

7. LED light source according to Claim 6, **characterized in that** a cooling body (11) is disposed on the rear side of the printed circuit board (9).

8. LED light source according to any one of the preceding Claims, **characterized in that** the printed circuit board (9) and/or the LED PCB (6) comprise through-connections to increase the thermal conductivity, wherein the through-connections preferably have a diameter of less than 100 μm.

9. LED light source according to any one of the preceding Claims, in which the die attach (4) is a die adhesive or a solder connection.

**Revendications**

1. Source lumineuse à DEL avec une ou plusieurs DEL disposées sur une platine (9),
où chacune des DEL présente au moins une puce de DEL (3) qui est disposée sur une carte de circuit imprimé de DEL (6) au moyen une attache de puce (4), et la carte de circuit imprimé de DEL (6) présente des contacts électriques de face arrière (7) sur la face située en face de la puce de DEL (3),
où les contacts de face arrière (7) recouvrent au moins la moitié de la surface, de préférence la surface entière, mis à part les cavités nécessaires, de la carte de circuit imprimé de DEL (6),
où la puce de DEL (3) est incorporée dans une matière (1) et la puce de DEL (3) est insérée dans un réflecteur, où la carte de circuit imprimé de DEL (6) est une platine à coeur métallique et la puce de DEL (3) est rapportée directement sur le coeur métallique,
où la platine (9) présente des surfaces de contact (8) avec lesquelles la DEL ou les DEL sont mises en contact, et
où les contacts de face arrière (7) de la DEL ou des DEL sont respectivement soudés sur au moins la moitié de la surface de la carte de circuit imprimé de DEL (6) avec les surfaces de contact (8).

2. Source lumineuse à DEL selon la revendication 1, **caractérisée en ce que** plusieurs puces de DEL (3) sont incorporées ensemble dans la matière (1).

3. Source lumineuse à DEL selon la revendication 1 ou la revendication 2, **caractérisée en ce que** plusieurs puces de DEL (3) sont insérées ensemble dans un réflecteur.

4. Source lumineuse à DEL selon l'une des revendications 1 à 3, **caractérisée en ce qu'**une matière isolante électriquement non linéaire est disposée entre des bandes conductrices (5) de la platine à coeur métallique et le coeur métallique de la platine à coeur métallique.

5. Source lumineuse à DEL selon l'une des revendications 1 à 4, **caractérisée en ce que** la puce de DEL (3) est montée face vers le bas ou face vers le haut sur la carte de circuit imprimé de DEL (6).

6. Source lumineuse à DEL selon l'une des revendications 1 à 5, **caractérisée en ce que** les contacts de face arrière (7) de la DEL ou des DEL sont soudés sur toute la surface, mis à part les cavités nécessaires, avec les surfaces de contact (8).

7. Source lumineuse à DEL selon la revendication 6, **caractérisée en ce qu'**un corps réfrigérant (11) est disposé sur la face arrière de la platine (9).

8. Source lumineuse à DEL selon l'une des revendications précédentes, **caractérisée en ce que** la platine (9) et/ou la carte de circuit imprimé de DEL (6) présente des contacts traversants pour l'augmentation de la conductivité thermique, où les contacts traversants présentent de préférence un diamètre inférieur à 100 $\mu$m.

9. Source lumineuse à DEL selon l'une des revendications précédentes, chez laquelle l'attache de puce (4) est un adhésif pour puce ou une soudure.

[Fig. 001]

1
2
3
4
5
6
7
8
9
10
11

[Fig. 002]

1
2
3
4
5
12
6
7

[Fig. 003]

1
2
3
4
5
6
7

**EP 2 398 080 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20020001192 A1
- JP 6037359 A
- JP 8264841 A
- US 6531328 B1
- DE 19963264 A1